# EUROPEAN PATENT SPECIFICATION

(11) **EP 0 369 554 B1**
(45) Date of publication and mention of the grant of the patent: **13.07.1994**
(21) Application number: 89203096.6
(22) Date of filing: 11.03.1988
(51) Int. Cl.: G01R 1/073, G01R 31/28

(54) **Apparatus for automatically scrubbing a surface**
Gerät zum automatischen Aufkratzen einer oxidierten Oberfläche
Appareil pour gratter automatiquement une surface oxydée

(30) Priority: 11.03.1987 US 24743
(43) Date of publication of application: 23.05.1990
(62) Divisional of application: 88302142.0
(73) Proprietor: Hewlett-Packard Company, Palo Alto, California 94304 (US)
(72) Inventor: Huff, Richard E., Belmont, CA 94002 (US); Perlaki, Miklos K., Rocklin, California 95677 (US)
(74) Representative: Williams, John Francis

(56) References cited:
- US-A- 4 103 232
- US-A- 4 649 339
- IBM TECHNICAL DISCLOSURE BULLETIN, vol. 10, no. 10, March 1968, page 1466, NewYork, US; F.H. DILL et al.: "Film supported probe for the AC pulse testing ofintegrated circuits"
- IBM TECHNICAL DISCLOSURE BULLETIN, vol. 13, no. 5, October 1970, page 1263, New
- York, US; F.M. REINHART: "Membrane type probe"

## Description

### FIELD OF THE INVENTION

The invention relates to the field of automatic surface scrubbers.

### BACKGROUND OF THE INVENTION

In order to conduct tests on the electronic components of a wafer, a test probe must form a low impedance connection with the wafer. Often, silicon wafers have contact pads coated with aluminum. This aluminum coating readily oxidizes into a non-conductive film 5 - 10 nm thick. When a test probe contacts this surface, the oxide film insulates the wafer from the test probe. In order to make a low impedance connection, the test probe must scrub the wafer's contact pads.

Wafer test probes commonly have numerous wires that dig into contact pads of the wafer under test. The digging ploughs oxide off the contact pads and permits a low impedance connection. If a test probe uses contact pads instead of wires, as described in EP 0230348 entitled Test Probe, published 29.07.87, the oxide remains on the wafer's contact pads and prevents the test probe from making a low impedance connection with the wafer. In order to perform the high frequency testing that modern day wafers require, the test probe must form a low impedance connection with the wafer. If the test probe cannot make a low impedance connection with the wafer, the high frequency tests must be delayed until the wafer is diced and packaged as chips. At this point, the loss is greater if a packaged chip must be discarded since the investment is greater.

An apparatus as described in US-A-4 649 339 removes oxide from the wafer contact pads. The apparatus forces the test probe pads to move sideways on the wafer contact pads when the test probe is forced against the wafer. This motion, known as scrubbing, breaks the oxide layer covering the wafer contact pads and exposes the fresh underlying metal. With the exposure to the fresh underlying metal, the test probe makes a low impedance connection with the wafer under test.

### SUMMARY OF THE INVENTION

The apparatus according to the present invention has one or more constant length pivot devices and one or more variable length springs connected between a base and a traveling device. When the traveling device moves away from the base, the constant length pivot device rotates about the base and pulls on the traveling device and the variable length spring. In response to the pulling force of the constant length pivot device, the variable length spring expands to accommodate the sideways motion of the traveling device. The traveling device's sideways motion towards the constant length pivot device produces scrubbing. A test probe, as described in EP-A-0 230 348 referenced above, connected to the traveling device scrubs the wafer contact pads.

The constant length pivot device is a leaf spring or a device equivalent to a leaf spring. The variable length spring has a leaf spring or a device equivalent to a leaf spring and expansion device that lengthens in the sideways direction. The expansion device can be an integral part of the traveling device and can have holes that expand in the direction of motion.

The present invention has the advantage of producing a controlled scrub of a wafer or other device. By controlling the parameters of the constant length pivot device and the variable length spring, one controls the scrub motion. When the present invention is used to scrub the contact pads of wafers, it has the additional advantage that all contact pads receive the same scrub motion.

### BRIEF DESCRIPTION OF THE DRAWINGS

Figure 1 shows the preferred embodiment of the invention.

Figure 2 shows a top view of the apparatus shown in Figure 1.

Figure 3 shows a cross section A-A designated in Figure 2.

Figure 4 shows an alternate embodiment of the variable length spring.

### DETAILED DESCRIPTION OF THE INVENTION

The items have been given a two-part number with a dash separating the parts. The number to the left of the dash refers to the figure number and the number to the right of the dash refers to the part number. Part numbers will remain unchanged from drawing to drawing.

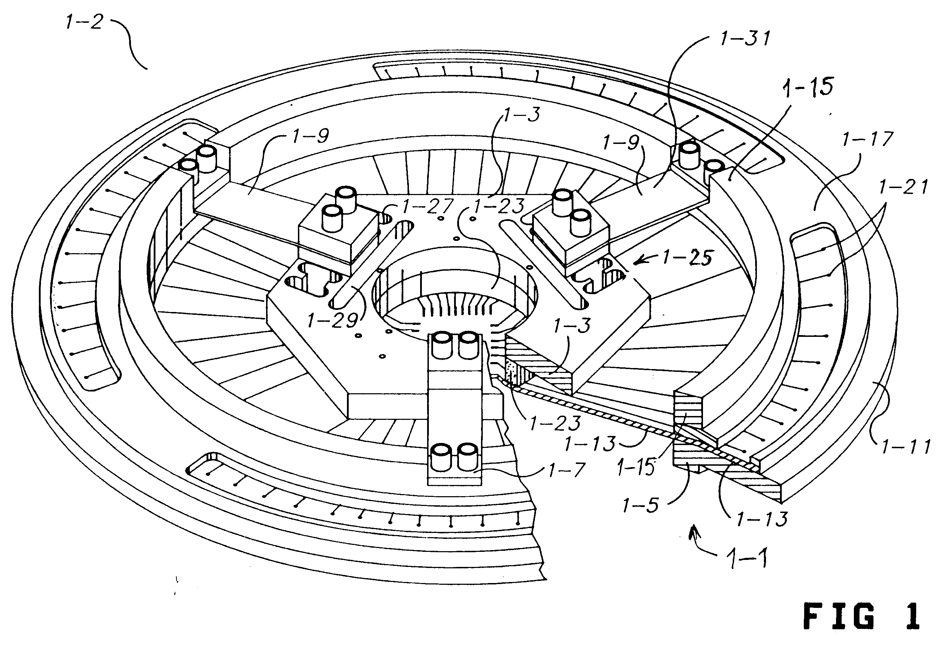

Figure 1 shows an apparatus according to the preferred embodiment of the invention. The cut away portion 1-1 shows a cross section of the apparatus. The travelling device 1-3 is connected to a base 1-5 through the constant length pivot device 1-7 and two variable length devices 1-9 located 120° apart. Alternate embodiments of the invention may use more than one constant length pivot device 1-7 and one or more variable length devices 1-9. In the preferred embodiment the invention, the base 1-5 has a base ring 1-15 attached to a base plate 1-11. As shown in the cut away, a membrane 1-13 is clamped between the base plate 1-11 and the base ring 1-15. In alternate embodiments of the invention, a mechanism which responds to pressure like the membrane probe described, viz., by moving sideways by about 20 microns to effect a scrubbing action on the test pads in contact, could be used instead of the membrane 1-13. In the preferred embodiment of the invention, the membrane 1-13 is a test probe membrane as discussed EP 0230348 mentioned above. A protective layer 1-17 resides between the base ring 1-15 and the base plate 1-11. This protective layer 1-17 protects the membrane 1-13 while exposing the test equipment contacts 1-21 which form interface ports receiving test signals for the probe.

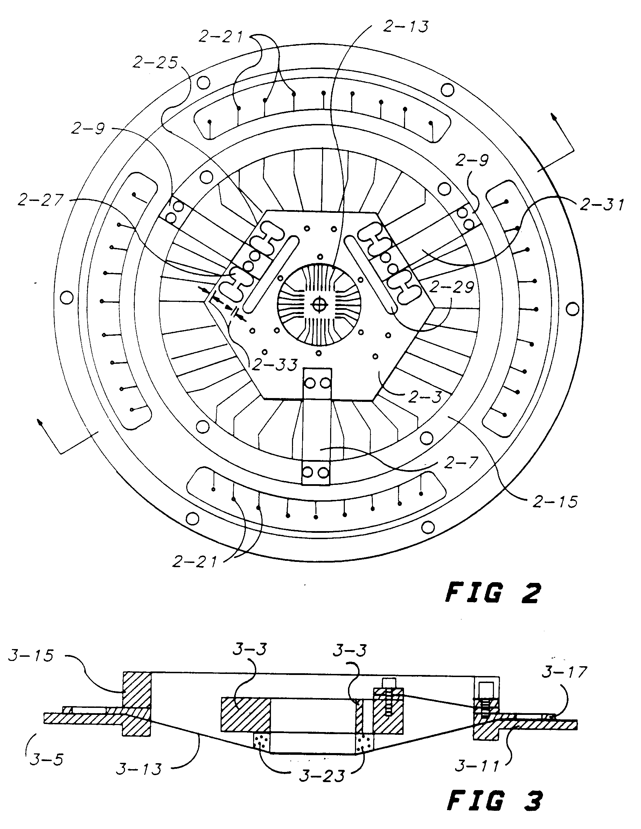

The membrane 1-13 engages with the travelling device 1-3 through an insulator 1-23. The insulator 1-23 is constructed from plastic such as 'lexan' (TM) and protects the delicate membrane 1-13 from abrading with the travelling means 1-3. More importantly, the insulator 1-23, 3-23 deflects the membrane 1-13, 3-13 away from the base 1-5, 3-5 as shown in Figure 3.

In the apparatus according to the preferred embodiment of the invention, the travelling device 1-3, 2-3 is a metal hexagonal plate, .31 cm thick. The travelling device 1-3, 2-3 has a large hole for visually aligning the membrane 1-13 with the wafer under test. In the preferred embodiment of the invention, the constant length spring device 1-7, 2-7 is a leaf spring connected between the travelling device 1-3 and the base ring 1-15. In alternate embodiments of the invention, the constant length pivot device 1-7 can have numerous embodiments such as rod, bar, or other stiff member connected between the travelling device 1-3 and the base ring 1-15 through pivot joints which allow the rod, bar, or other stiff member to rotate.

In the preferred embodiment of the invention, the variable length spring 1-9 has a expansion device 1-25 and a leaf spring 1-31 that is connected between the base ring 1-15 and the expansion device 1-25. The leaf spring 1-31 is very similar to the constant length pivotal device 1-7. Likewise, the leaf spring 1-31 can be replaced by a rod, bar, or other stiff member connected between base ring 1-15 and the expansion device 1-25 through a pivot joint. In the preferred embodiment of the invention, the expansion device 1-25 is an integral part of the traveling device 1-3. In alternate embodiments of the invention, the expansion device 1-25 may be a separate component. The expansion device 1-25 lengthens in the direction of the traveling device's 1-3 sideways motion. In the preferred embodiment, each variable length spring has one expansion device 1-25. Each expansion device 1-25 has two H-shaped holes 1-27 and one elongated hole 1-29. ln operation, the constant length pivotal device 1-7 pulls the traveling device 1-3 towards itself. The H-shaped holes 1-27 are weak in this direction and expand under the pulling force. Additionally, the two elongated holes 1-29 are weak in the direction of the traveling device's 1-3 motion. When the H-shaped holes 1-27 and the elongate holes 1-29 expand in the direction of the constant length pivot device 1-7, the traveling device 1-3 and the attached membrane 1-14 move sideways.

The spring rate of the variable length spring 1-9 depends primarily on three major factors. The stiffness of the web which is determined by the web thickness 2-33; the distance across the two H-shaped holes 1-27; and the dimensions of the constant length spring 1-7. In the preferred embodiment of the invention, the web thickness is .38 cm throughout the variable length spring 1-9. And the constant length pivotal device has a length equal to .95 cm width equal to .63 cm and a thickness equal to .03 cm. The resulting variable length spring 1-9 has spring rate of 0.44 meganewtons/metre (2500 lb/in). With this spring rate, the constant length pivot device 1-7 must pull on the variable length spring device with a force of 8.88 newtons (2 lb) to make the variable length spring device move sideways 20 microns. The H-shaped hole 1-27 reduces the spring rate and thereby reduces the force the constant length pivot device 1-7 must exert in order to produce a sideways motion of 20 microns. This has the advantage of reducing the force between the wafer and the test probe.

The apparatus, according to the preferred embodiment of the invention, is designed so that the traveling device 1-3 does not tilt. There are several features of the traveling device 1-3 and the expansion device 1-25 that prevent the tilting. The traveling device 1-25 is thick so that it does not bend. Additionally, the H-shaped holes 1-27 and the elongated holes 1-29 are designed to be weak in the sideways direction of travel but strong in every other direction. The H-shaped holes 1-27 can be viewed as rectangular hole with metal extensions into the holes which make the traveling device, in the vicinity of the hole, resistent to bending or tilting. Alternate embodiments of the invention may have a expansion device with holes having a different shape without departing from the scope of the invention. Additionally, tilting of the travelling device 1-3 may be acceptable or even desirable in some applications. The resulting alternate embodiments may allow tilting without departing from the scope of the present invention. In other alternate embodiments, the expansion device 1-25 may have an accordian or other structure that expand when placed under tension. Such an embodiment does not depart from the scope of the present invention.

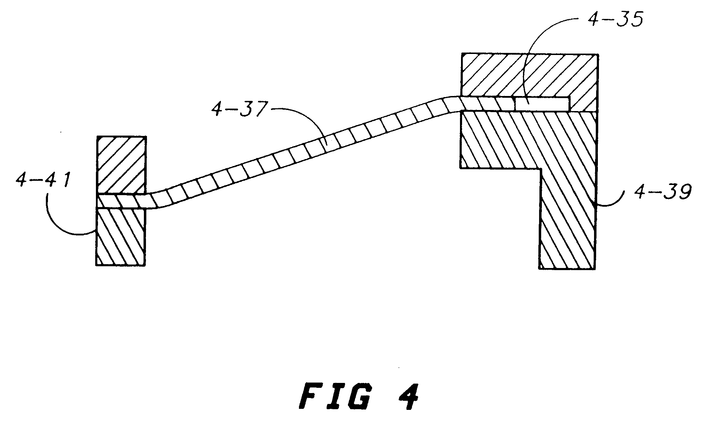

An alternate embodiment of the invention uses the variable length spring shown in Figure 4. A flexture pivot 4-37 moves out of the confinement slot 4-35 as the travelling device 4-39 is pushed away from the base 4-41. The confinement slot 4-35 confines the motion of the flexture pivot 4-37 to the horizontal plane and only allows the flexture pivot 4-37 to apply verticle forces to the travelling device 4-39. This embodiment has the advantage that no sideways forces or torques are applied to the travelling device 4-39 or the flexture pivot 4-37.

An apparatus according to the preferred embodiment of the invention is used as follows: The test wafer is pushed against the probe card at its contact area (1-13, 2-13). Specifically, the wafer is held on a chuck; it is then stepped and position directly under the probe card, which is held in a fixed position by a "prober" harness. Once the wafer is in position, that is aligned to the contacts on the probe card, the chuck is activated to push the wafer against the probe card contacts. As the probe card makes contact with the wafer, its contact pads (2-13) are pushed and forced to move sideways by about 20 microns to slightly abrade the surface of the test wafer contact pads. This action results in clean metal on the contacts for making good electrical contact.

Pushing a wafer against the test probe membrane 1-13 causes the travelling means 1-3 to lift out of the resting position shown in Figure 1. When the wafer pushes the travelling device 1-3 out of its resting position, the constant length pivot device 1-7 rotates upwards and thereby exerts a force on the traveling device 1-3 which tends to pull it towards the constant length pivot device 1-7. The leaf springs 1-31 of the variable length spring device 1-9 also rotates upwards. In response to forces exerted by the constant length pivotal device 1-7, the expansion device 1-25 lengthens to allow the traveling device 1-3 and the attached membrane 1-13 to move sideways toward said constant length pivot device 1-7. The expansion device 1-25 lengthens by the expansion of the H-shaped hole 1-27 and the elongated hole 1-29 in the direction of the constant length pivot device 1-7.

The apparatus according to the preferred embodiment of the present invention is manufactured by drilling the elongated holes 1-29 and the H-shaped holes 1-27 into a plate of metal .31 cm thick. The drill has a diameter of .16 cm

Three leaf springs 1-7 and 1-31 of equal length are mounted between the base 1-5 and the traveling device 1-3. The leaf springs are located 120 degrees apart so that they will act symmetrically. Two leaf springs are located adjacent to the extension device 1-25. The membrane 1-13 is glued to an insulator ring 1-23 which is mounted on the traveling device 1-3. A solid spring is placed on top of the traveling device 1-3. In the preferred embodiment of the invention, an apparatus for aligning the membrane 1-13 with the wafer under test is attached to the apparatus 1-2.

## Claims

1. An apparatus for scrubbing the contact pads of a device under test (DUT) the apparatus comprising: a flexible membrane (1-13), formed to be stretched; a travelling device (1-3) formed with an upper surface and with a lower surface including a penetrating, insulating lower ring portion (1-23) defining an aperture through said travelling device (1-3), the aperture being formed for mounting the membrane (1-13), contact pads (1-21) on the membrane (1-13) being intended to contact and scrub the contact pads on the device under test, causing removal of oxide from the pads on the device under test ; and a carrier (1-11) coupled to the travelling device (1-3); the apparatus characterised in that it further comprises a first means comprising a fixed length flexure pivot assembly (1-7), and a second means comprising a plurality of variable length flexure pivot assemblies (1-9), and in that the carrier (1-11) is coupled to the upper surface of the travelling device (1-3) by the first means and by at least one of the second means.

2. An apparatus according to claim 1, wherein the travelling device (1-3) has a hexagonal geometry.

3. An apparatus according to claims 1 or 2 wherein the fixed length flexure pivot assembly (1-7) further comprises: a leaf spring; a first pair of compression blocks mounted on the carrier (1-11); and a second pair of compression blocks mounted on the travelling device (1-3).

4. An apparatus according to any preceding claim wherein the variable length pivot assembly (1-9) further comprises: a leaf spring (1-31); a first pair of compression blocks (4-41) mounted on the carrier (1- 11); a second pair of compression blocks (4-35, 4-39) mounted on the travelling device (1-3); and an expansion spring (1-25) formed on the travelling device.

5. An apparatus according to claim 4, wherein the expansion spring (1-25) further comprises: a pair of "H" shaped lateral slots (1-27); and a narrow transverse slot (1-29); each of the lateral slots and the transverse slot being positioned to substantially surround the second pair of compression blocks (4-35, 4- 39) mounted on the travelling device (1-3).

6. An apparatus according to any preceding claim wherein the membrane (1-13) further comprises: a plurality of signal conducting signal traces having signal trace terminals, the signal traces being formed on an upper side of the membrane to be facing toward the travelling device (1-3); and the contact pads on the membrane comprises a plurality of contact bumps (1-21) formed on a lower side of the membrane to be facing away from the travelling device, positioned toward a central portion of the membrane within the insulating lower ring (1-23) of the travelling device, and electrically coupled through the membrane to the signal traces and the terminals residing on the upper side of the membrane.

7. An apparatus according to claim 6, wherein the carrier (1-11) further comprises: a protective layer (1- 17) placed over the membrane, formed to have a plurality of slots penetrating the protective layer to allow access to the signal trace terminals on the upper side of the membrane.

## Patentansprüche

1. Eine Vorrichtung zum Schrubben der Kontaktanschlußflächen eines Prüflings (DUT), wobei die Vorrichtung folgende Merkmale aufweist:
eine bewegliche Membran (1-13), die gebildet ist, um gedehnt zu werden;
ein verschiebbares Bauteil (1-3), das mit einer oberen Oberfläche und mit einer unteren Oberfläche gebildet ist, das einen durchdringenden, isolierenden unteren Ringabschnitt (1-23), der eine Öffnung durch das verschiebbare Bauteil (1-3) definiert, einschließt, wobei die Öffnung zur Befestigung der Membran (1-13) gebildet ist, wobei Kontaktanschlußflächen (1-21) auf der Membran (1-13) vorgesehen sind, um die Kontaktanschlußflächen auf dem Prüfling zu kontaktieren und zu schrubben, wobei die Entfernung des Oxids von den Anschlußflächen des Prüflings verursacht wird; und
einen Träger (1-11), der mit dem verschiebbaren Bauteil (1-3) gekoppelt ist;
dadurch gekennzeichnet,
daß die Vorrichtung ferner eine erste Einrichtung, die eine Kreuzfedergelenkanordung (1-7) mit fester Länge umfaßt, und eine zweite Einrichtung, die eine Mehrzahl von Kreuzfedergelenkanordnungen (1-9) mit variabler Länge umfaßt, aufweist; und
daß der Träger (1-11) mit der oberen Oberfläche des verschiebbaren Bauteils (1-3) durch die erste Anordnung und durch mindestens eine der zweiten Anordnung gekoppelt ist.

2. Eine Vorrichtung nach Anspruch 1, bei der das verschiebbare Bauteil (1-3) eine sechseckige Geometrie hat.

3. Eine Vorrichtung nach Anspruch 1 oder 2, bei der die Kreuzfedergelenkanordnung (1-7) mit fester Länge ferner eine Blattfeder, ein erstes Paar von Kompressionsblöcken, die auf dem Träger (1-11) montiert sind; und ein zweites Paar von Kompressionsblöcken, die auf dem verschiebbaren Bauteil (1-3) montiert sind, umfaßt.

4. Eine Vorrichtung nach irgendeinem vorangegangenen Anspruch, bei der der drehbare Aufbau (1-9) mit variabler Länge ferner eine Blattfeder (1-31), ein erstes Paar von Kompressionsblöcken (4-41), die auf dem Träger (1-11) befestigt sind, ein zweites Paar von Kompressionsblöcken (4-35, 4-39), die auf dem verschiebbaren Bauteil (1-3) befestigt sind, und eine Expansionsfeder (1-25), die auf dem verschiebbaren Bauteil gebildet ist, umfaßt.

5. Eine Vorrichtung gemäß Anspruch 4, bei der die Expansionsfeder (1-25) ferner ein Paar von "H"-förmigen lateralen Schlitzen (1-27); und einen engen transversalen Schlitz (1-29) umfaßt; wobei jeder der lateralen Schlitze und der transversale Schlitz angeordnet sind, um im wesentlichen das zweite Paar von Kompressionsblöcken (4-35, 4-39), die auf dem verschiebbaren Bauteil (1-3) befestigt sind, zu umgeben.

6. Eine Vorrichtung nach irgendeinem vorangegangenen Anspruch, bei der die Membran (1-13) ferner eine Mehrzahl von Signal-leitenden Signalspure umfaßt, die Signalspuranschlüsse haben, wobei die Signalspuren auf einer oberen Seite der Membran gebildet sind, um in Richtung des verschiebbaren Bauteils (1-3) zu zeigen; wobei die Kontaktanschlußflächen auf der Membran eine Mehrzahl von Kontakterhebungen (1-21) umfassen, die auf einer unteren Seite der Membran gebildet sind, um von dem verschiebbaren Bauteil wegzuzeigen, die auf einen Mittelabschnitt der Membran innerhalb des isolierenden unteren Rings (1-23) des verschiebbaren Bauteils angeordnet sind, und elektrisch durch die Membran mit den Signalspuren und den Anschlüssen, die auf der oberen Seite der Membran angeordnet sind, gekoppelt sind.

7. Eine Vorrichtung gemäß Anspruch 6, bei der der Träger (1-11) ferner eine Schutzschicht (1-17) umfaßt, die über die Membran plaziert ist, die gebildet ist, um eine Mehrzahl von Schlitzen zu haben, die in die Schutzschicht eindringen, um Zugriff auf die Signalspuranschlüsse auf der oberen Seite der Membran zuzulassen.

## Revendications

1. Appareil pour gratter les plots de contact d'un dispositif en cours de vérification (DUT), l'appareil comportant: une membrane souple (1-13) constituée de façon à être étirée; un dispositif mobile (1-3) constitué avec une surface supérieure et avec une surface inférieure comportant une partie inférieure en anneau pénétrante, isolante (1-23), définissant une ouverture à travers ledit dispositif mobile (1-3), l'ouverture étant constituée pour le montage de la membrane (1-13), des plots de contact (1-21) situés sur la membrane (1-13) étant destines à être en contact avec et à gratter les plots de contact du dispositif en cours de vérification, provoquant l'élimination d'oxyde des plots du dispositif en cours de vérification; et un support (1-11) couplé au dispositif mobile (1-3); l'appareil étant caractérisé en ce qu'il comporte en outre un premier moyen comportant un montage de pivot souple de longueur fixe (1-7), et un second moyen comportant plusieurs montages de pivots souples de longueurs variables (1-9), et en ce que le support (1-11) est couplé à la surface supérieure du dispositif mobile (1-3) par le premier moyen et par au moins l'un des seconds moyens.

2. Appareil selon la revendication 1, dans lequel le dispositif mobile (1-3) est de géométrie hexagonale.

3. Appareil selon les revendications 1 ou 2, dans lequel le montage de pivot souple de longueur fixe (1-7) comporte en outre: un ressort à lames; une première paire de blocs de compression montée sur le dispositif mobile (1-3); et une seconde paire de blocs de compression montée sur le dispositif mobile (1-3).

4. Appareil selon l'une quelconque des revendications précédentes, dans lequel le montage de pivot souple de longueur variable (1-9) comporte en outre: un ressort à lames (1-31); une première paire de blocs de compression (4-41) montée sur le support (1-11); une seconde paire de blocs de compression (4-35, 4-39), montée sur le dispositif mobile (1-3); et un ressort de dilatation (1-25) constitué sur le dispositif mobile.

5. Appareil selon la revendication 4, dans lequel le ressort de dilatation (1-25) comporte en outre: une paire de fentes latérales en forme de "H" (1-27); et une fente transversale étroite (1-29); chacune des fentes latérales et la fente transversale étant positionnées de façon à entourer sensiblement la seconde paire de blocs de compression (4-35, 4-39) montée sur le dispositif mobile (1-3).

6. Appareil selon l'une quelconque des revendications précédentes, dans lequel la membrane (1-13) comporte en outre: plusieurs pistes pour signal conductrices de signal ayant des bornes de piste de signal, les pistes de signal étant formées sur le côté supérieur de la membrane de façon à se trouver face au dispositif mobile (1-3); et les plots de contact situés sur la membrane comportant plusieurs heurtoirs de contact (1-21) constitués sur le côté inférieur de la membrane tournés vers l'extérieur du dispositif mobile, positionnés vers la partie centrale de la membrane à l'intérieur de l'anneau inférieur isolant (1-23) du dispositif mobile, et couplés électriquement à travers la membrane aux pistes de signal et aux bornes situées sur le côté supérieur de la membrane.

7. Appareil selon la revendication 6, dans lequel le support (1-11) comporte en outre: une couche protectrice (1-17) placée au-dessus de la membrane, constituée de façon à comporter plusieurs fentes pénétrant dans la couche protectrice afin de permettre l'accès aux bornes de piste de signal situées du côté supérieur de la membrane.
